# EUROPEAN PATENT SPECIFICATION

(11) **EP 1 335 412 B1**
(45) Date of publication and mention of the grant of the patent: **27.02.2008**
(21) Application number: 03001859.2
(22) Date of filing: 29.01.2003
(51) Int. Cl.: H01L 21/00

(54) **Substrate treatment apparatus and substrate treatment method**
Vorrichtung und Verfahren zur Substratbehandlung
Dispositif et procédé de traitement de substrat

(30) Priority: 30.01.2002 JP 2002022089; 26.03.2002 JP 2002086359; 17.12.2002 JP 2002365653
(43) Date of publication of application: 13.08.2003
(73) Proprietor: Dainippon Screen Mfg. Co., Ltd., Kyoto 602-8585 (JP)
(72) Inventor: Izumi, Akira, c/o DAINIPPON SCREEN MFG. CO., LTD., Horikawa-dori Kamikyo-ku, Kyoto 602-8585 (JP); Kiyose, Hiromi, c/o DAINIPPON SCREEN MFG. CO., LTD, Horikawa-dori Kamikyo-ku, Kyoto 602-8585 (JP); Noguchi, Sachiko, DAINIPPON SCREEN MFG. CO., LTD., Horikawa-dori c/o Kamikyo-ku, Kyoto 602-8585 (JP)
(74) Representative: Goddar, Heinz J.

(56) References cited:
- EP-A- 0 294 690
- EP-A- 0 805 484
- EP-A- 1 091 388
- US-A- 5 454 901
- US-A- 5 679 171
- US-A- 5 918 817
- US-A- 5 934 566
- US-A1- 2001 052 354
- PATENT ABSTRACTS OF JAPAN vol. 017, no. 203 (E-1354), 21 April 1993 (1993-04-21) -& JP 04 346431 A (MITSUBISHI ELECTRIC CORP), 2 December 1992 (1992-12-02)
- PATENT ABSTRACTS OF JAPAN vol. 1998, no. 14, 31 December 1998 (1998-12-31) -& JP 10 256211 A (SONY CORP), 25 September 1998 (1998-09-25)

## Description

### BACKGROUND OF THE INVENTION

### Field of the Invention

The present invention relates to a substrate treatment apparatus and a substrate treatment method for cleaning a surface of a substrate such as a semiconductor substrate.

### Description of Related Art

In a semiconductor device production process, particles and metal contaminants are liable to adhere on a surface of a semiconductor wafer (hereinafter referred to simply as "wafer") . Therefore, the surface of the wafer should be cleaned at a proper stage. Wafer cleaning methods include : a multiple-wafer batch process in which a multiplicity of wafers are immersed in a cleaning liquid at a time; and a wafer-by-wafer process in which wafers are treated on a wafer-by-wafer basis by supplying a cleaning liquid onto a surface of a single wafer while rotating the wafer. The wafer-by-wafer cleaning process is disadvantageous in that more time is required for cleaning a single wafer as compared with the multiple-wafer batch cleaning process, but has a process advantage.

Therefore, cleaning methods suitable for the wafer-by-wafer process have been developed. For example, Japanese Patent Publication JP 10-256211 (1998) discloses a cleaning method which employs ozone water and dilute hydrofluoric acid as cleaning liquids. In this prior-art technique, ozone water is supplied onto a wafer surface, whereby the wafer surface is oxidized. Then, dilute hydrofluoric acid is supplied onto the wafer surface, whereby the resulting oxide layer on the wafer surface is selectively etched away. Thus, metal contaminants (deposited metals) adhering on the wafer surface are removed together with the oxide layer. Since the layer which bears the particles on the wafer surface is removed, the particles are also removed (lifted off).

EP 0805484 discloses a particle removing process with use of mixture of ammonia and aqueous hydrogen peroxide followed by an etching process.

However, the aforesaid prior-art technique presents a problem such that a greater amount of the wafer surface is etched away (e.g., an etch thickness is 20Å). That is, the wafer surface should be etched to a greater thickness for the removal of the particles and the deposited metals in the aforesaid method.

US 5934566 discloses a washing apparatus provided with a jet nozzle which generate droplets by mixing a liquid and a gas.

### SUMMARY OF THE INVENTION

It is an object of the present invention to provide a substrate treatment apparatus which is capable of treating a single substrate at a time with a reduced substrate etch amount.

It is another object of the present invention to provide a substrate treatment apparatus which is capable of treating a single substrate at a time to clean a surface of the substrate in a shorter time.

It is further another object of the present invention to provide a substrate treatment method in which a single substrate is treated at a time with a reduced substrate etch amount.

It is still another object of the present invention to provide a substrate treatment method in which a single substrate is treated at a time to clean a surface of the substrate in a shorter time.

A substrate treatment apparatus and a method therefor according to the present invention are described respectively in claim 1 and 10.

According to the present invention, particles adhering on the substrate surface can physically be removed by a kinetic energy of the droplets of the pretreatment liquid bombarded against the substrate. The particles once removed from the substrate surface are chemically prevented from adhering again onto the substrate by a repulsive force due to a ζ potential. In addition, the pretreatment liquid is supplied in a liquid droplet form, so that the substrate per se is not subjected to an excessively great force. Even if the substrate to be treated is, for example, a semiconductor substrate having a pattern formed on its surface, there is no possibility that the pattern is damaged. Further, the removal of the particles can be achieved in a shorter time by this physical and chemical method.

With the use of the pretreatment liquid containing ammonia, copper (Cu) deposited as a metal deposit on the substrate surface can be dissolved in the form of an ammine complex. Ammonia may be present as aqueous ammonia (NH₄OH) in the pretreatment liquid.

The pretreatment liquid may be adapted to pretreat the substrate surface into a state suitable for the etching prior to the etching. Where the substrate is a semiconductor substrate such as a silicon substrate, for example, the substrate surface can be oxidized by employing the solution mixture including ammonia and the oxidizing agent as the pretreatment liquid.

After the pretreatment process, the substrate surface can properly be etched for removal of deposited metals and the like with the use of the etching liquid capable of selectively dissolving the resulting oxide layer on the surface of the semiconductor substrate. At this time, the particles are already removed, so that it is merely necessary to etch the substrate surface to a smaller thickness. Therefore, the substrate etch amount can be reduced.

The substrate treatment apparatus may further comprise a substrate holding/rotating mechanism for holding and rotating the substrate. By rotating the substrate, the pretreatment process and the etching process can uniformly be performed on the substrate surface. The substrate treatment apparatus may further comprise a pure water supplying mechanism for supplying pure water onto the substrate. In this case, the substrate surface can be rinsed with the pure water supplied thereto after the etching process and between the pretreatment process and the etching process.

The oxidizing agent may be, for example, hydrogen peroxide.

The solution mixture as the pretreatment liquid may further comprise water. Where the substrate is a semiconductor substrate such as a silicon substrate, for example, the substrate surface can be oxidized with the use of the pretreatment liquid having such a composition. Thereafter, the resulting oxide layer on the substrate surface is etched away with the etching liquid, whereby the deposited metals can advantageously be removed. That is, the substrate surface can be pretreated into a state suitable for the etching with the use of the pretreatment liquid prior to the etching.

Solution mixtures containing aqueous ammonia, hydrogen peroxide (H₂O₂) and water (H₂O) in a wide range of ratios are effective as the pretreatment liquid, but the mixing ratios are preferably 0.05 to 1 part by volume of the aqueous ammonia, 0.1 to 1 part by volume of hydrogen peroxide, and 5 parts by volume of water.

The oxidizing agent may be ozone water. Where the substrate is a semiconductor substrate such as a silicon substrate, for example, the substrate surface can be oxidized with the use of the pretreatment liquid having such a composition. Thereafter, the resulting oxide layer on the substrate surface is etched away with the use of the etching liquid, whereby the deposited metals can advantageously be removed.

Solution mixtures containing aqueous ammonia and the ozone water in a wide range of ratios are effective as the pretreatment liquid, but the mixing ratios are preferably 5 to 50 parts by volume of ozone water having an ozone concentration of 5 to 30 ppm, and 1 part by volume of aqueous ammonia.

The concentrations of the chemical components in the pretreatment liquid may properly be determined depending on the temperature of the pretreatment liquid when it is used. More specifically, the concentrations may be set lower when the pretreatment liquid is used at a higher temperature (e.g., 50 to 80°C), and set higher when the pretreatment is used at a lower temperature (e.g., around an ordinary temperature).

Where pretreatment liquid containing aqueous ammonia and hydrogen peroxide as the chemical components is used at an ordinary temperature (20 to 28° C), the mixing volume ratio of aqueous ammonia, hydrogen peroxide and water may be about 1:1:5. Where pretreatment liquid having such a composition is used at a higher temperature, the concentrations of aqueous ammonia and hydrogen peroxide may be set lower.

With the use of pretreatment liquid having such a composition, the surface of the semiconductor substrate can advantageously be oxidized, and the repulsive force due to the ζ potential can advantageously be provided. Therefore, the deposited metals can highly effectively be removed during the etching. Since the pretreatment process can be performed in a short time (several tens seconds), the amount of the substrate etched by the pretreatment liquid is negligible.

The pretreatment section preferably comprises a bi-fluid nozzle including a pretreatment liquid ejecting section for ejecting the pretreatment liquid, and a gas ejecting section provided adjacent the pretreatment liquid ejecting section for ejecting a gas, the bi-fluid nozzle being capable of blowing the gas ejected from the gas ejecting section on the pretreatment liquid ejected from the pretreatment liquid ejecting section for the generation of the droplets of the pretreatment liquid and ejecting the liquid droplets onto the substrate surface.

The pretreatment liquid can be disintegrated into minute liquid droplets by ejecting the pretreatment liquid from the pretreatment liquid ejecting section, ejecting a high pressure gas (compressed air or an inert gas such as nitrogen (N₂) gas) from the gas ejecting section, and blowing the high-pressure gas laterally on the ejected pretreatment liquid. The size of the droplets of the pretreatment liquid and the bombardment speed against the substrate can be controlled by adjusting the pressure of the high pressure gas. The bi-fluid nozzle may be such that the liquid droplets are generated by blowing the gas on the liquid in an open space (external mixing), or such that the liquid droplets are generated by blowing the gas on the liquid in an ejection nozzle and ejected from the ejection nozzle (internal mixing).

The etching liquid may be a solution mixture comprising hydrofluoric acid (HF) and hydrochloric acid (HCl). By employing hydrochloric acid in addition to hydrofluoric acid, the etching liquid has an improved capability of dissolving the deposited metals, so that the deposited metals can be removed with a smaller etch amount. Therefore, the substrate surface etch amount can be reduced (e.g., to an etch thickness of 2Å). This etching liquid has a sufficient capability of dissolving the deposited metals, even if the temperature of the etching liquid is around an ordinary temperature (20 to 28°C).

By employing etching liquid having such a composition and pretreatment liquid having the aforesaid composition, the cleaning process from the removal of the particles to the removal of the deposited metals can be performed in a shorter time.

A substrate treatment method according to the present invention comprises the steps of: bombarding liquid droplets onto a surface of a substrate for pretreatment of the substrate surface, the liquid droplets being generated by mixing a pretreatment liquid comprising ammonia and an oxidizing agent with a gas; and supplying an etching liquid onto the substrate surface after the pretreatment.

The pretreatment liquid and the etching liquid preferably each have a temperature of 20 to 28°C. Even if the temperatures of the pretreatment liquid and the etching liquid are 20 to 28°C as described above, the intended effects can be ensured. That is, there is no need for adjusting the liquid temperatures by heating the liquids, so that the treatment of the substrate can be facilitated. More preferably, the pretreatment liquid and the etching liquid each have a temperature of 20 to 25°C.

The foregoing and other objects, features and effects of the present invention will become more apparent from the following description of the preferred embodiments with reference to the attached drawings.

### BRIEF DESCRIPTION OF THE DRAWINGS

Fig. 1 is a schematic sectional view illustrating the construction of a substrate treatment apparatus according to one embodiment of the present invention, particularly illustrating a state thereof in a pretreatment process;
Fig. 2 is a schematic sectional view illustrating the construction of a bi-fluid nozzle;
Fig. 3 is a schematic plan view for explaining the action of the bi-fluid nozzle relative to a wafer held by a spin base in the pretreatment process;
Fig. 4 is a schematic sectional view illustrating a state of the substrate treatment apparatus shown in Fig. 1 in an etching process;
Fig. 5 is a schematic sectional view illustrating a state of the substrate treatment apparatus shown in Fig. 1 in a water rinsing process and a drying process;
Fig. 6 is a diagram showing particle removal ratios at which particles were removed from a wafer surface after the pretreatment process and after the etching process;
Fig. 7 is a diagram showing the amounts of metals deposited on the wafer surface before and after a cleaning process sequence;
Fig. 8 is a diagram showing particle removal ratios at which particles were removed from surfaces of wafers after the cleaning process was performed by employing pretreatment liquids having different compositions;
Fig. 9 is a diagram showing the amounts of various metals deposited on the wafer surface after the cleaning process;
Fig. 10 is a diagram showing relationships between a pretreatment period and the particle removal ratio at which particles were removed from the wafer surface;
Fig. 11 is a diagram showing the amounts of copper deposited on the wafer surface before and after the cleaning process was performed with different etching periods
Fig. 12 is a diagram showing a relationship between a wafer etching period and an etch thickness; and
Fig. 13 is a diagram showing the amounts of chlorine on the wafer surface after the cleaning process was performed with different water rinsing periods.

### DESCRIPTION OF THE PREFERRED EMBODIMENTS

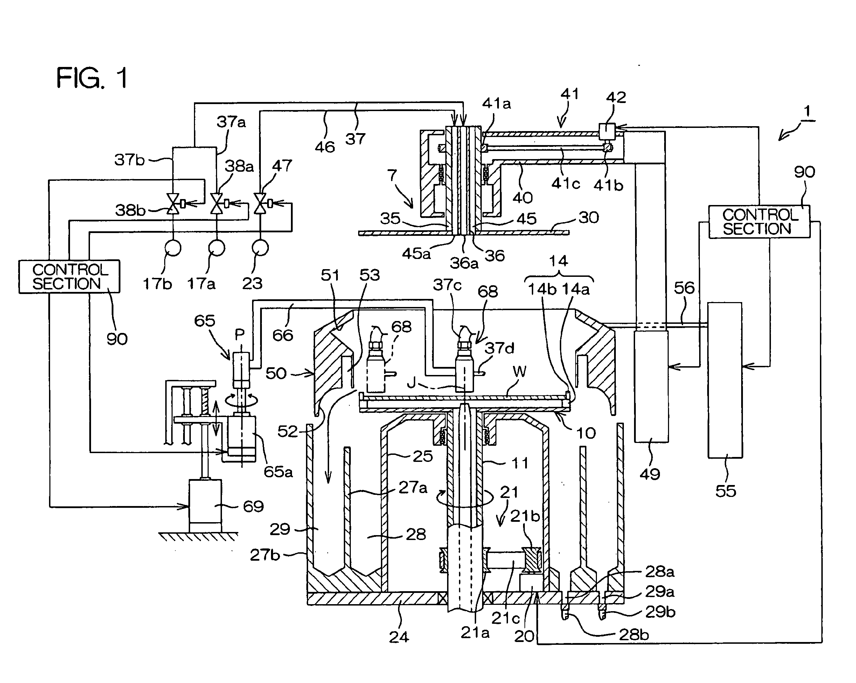

Fig. 1 is a schematic sectional view illustrating the construction of a substrate treatment apparatus 1 according to one embodiment of the present invention, particularly illustrating a state thereof in a pretreatment process.

The substrate treatment apparatus 1 is adapted to clean a surface of a semiconductor wafer W of silicon (herein after referred to simply as "wafer W"), and includes a spin base 10 for holding and rotating the wafer W, a bi-fluid nozzle 68 for supplying droplets of a pretreatment liquid onto the wafer W held by the spin base 10, a treatment liquid supplying section 7 for supplying a treatment liquid such as an etching liquid onto the wafer W held by the spin base 10, and a splash guard 50 for receiving treatment liquids (the pretreatment liquid, the etching liquid, water and the like) spun off from the wafer W held and rotated by the spin base 10.

The spin base 10 is a disk-shaped member, and includes a plurality of chuck pins 14 (e.g., six chuck pins 14) provided upright on the spin base for holding a peripheral portion of the round wafer W. The chuck pins 14 are provided equiangularly (e.g., at an angular interval of 60 degrees) about the center of the spin base 10 along the circumference of the spin base 10. The chuck pins 14 each include a substrate support 14a for supporting the peripheral portion of the wafer W from a lower side, and a substrate holder 14b for holding the wafer W by pressing the outer circumferential surface of the wafer W supported by the substrate supports 14a. The chuck pins 14 are adapted to be switched between a pressing state in which the substrate holders 14b are pressed against the outer circumferential surface of the wafer W and a non-pressing state in which the substrate holders 14b are spaced apart from the outer circumferential surface of the wafer W. The wafer W held by the chuck pins 14 is kept in a generally horizontal attitude.

A hollow cylindrical rotation shaft 11 extends vertically from the center of a lower surface of the spin base 10. The rotation shaft 11 further extends downward through a plate base member 24 horizontally provided. A torque is transmitted to the rotation shaft 11 from a motor 20 mounted on the base member 24 via a belt drive mechanism 21.

The belt drive mechanism 21 includes a driven pulley 21a attached to the rotation shaft 11, a driving pulley 21b attached to a rotation shaft of the motor 20, and a belt 21c stretched between the driven pulley 21a and the driving pulley 21b. Thus, the rotation shaft 11 is rotatable about a vertical axis J by a rotative driving force from the motor 20. When the rotation shaft 11 is rotated, the spin base 10 and the wafer W held by the spin base 10 are rotated about the axis J. Apart of the rotation shaft 11, the belt drive mechanism 21 and the motor 20 are housed in a hollow cylindrical closed-top casing 25 provided on the base member 24.

On the base member 24, a hollow cylindrical partition member 27a is provided upright as surrounding the casing 25, and another hollow cylindrical partition member 27b is provided upright as surrounding the partition member 27a. A first liquid drain chamber 28 is defined between the casing 25 and the partition member 27a, which serve as side walls thereof. A second liquid drain chamber 29 is defined between the partition member 27a and the partition member 27b, which serve as side walls thereof. The first liquid drain chamber 28 has a V-shaped trench provided on the bottom thereof, and a drain port 28a provided in a middle portion of the V-shaped trench in communication with a waste drain 28b. Similarly, the second liquid drain chamber 29 has a V-shaped trench provided on the bottom thereof, and a drain port 29a provided in a middle portion of the V-shaped trench in communication with a recovery drain 29b.

The annular splash guard 50 as seen in plan is provided above the second liquid drain chamber 29. A groove-like first guide 51 having a chevron-shaped cross section is provided as opening inward in an upper interior portion of the splash guard 50. In a lower portion of the splash guard 50, a second guide 52 having a quarter-circle-shaped cross section is provided as opening inwardly downward, and an annular groove 53 is formed as opening vertically downward in the innermost portion of the second guide 52. The splash guard 50 is coupled to a guard lift mechanism 55 via a link member 56 so as to be moved up and down by a driving force of the guard lift mechanism 55. When the splash guard 50 is moved down, the groove 53 is loosely engaged with an upper portion of the partition member 27a.

The treatment liquid supplying section 7 includes a disk-shaped ambient shield plate 30, a tubular rotation shaft 35 extending vertically from the center of an upper surface of the ambient shield plate 30, and a treatment liquid pipe 36 extending within the rotation shaft 35. An opening having a diameter generally equal to the inner diameter of the rotation shaft 35 is formed in the center of the ambient shield plate 30. The rotation shaft 35 is rotatably supported by a support arm 40 via a bearing, and is coupled to a motor 42 attached to the support arm 40 via a belt drive mechanism 41. The belt drive mechanism 41 includes a driven pulley 41a attached to the rotation shaft 35, a driving pulley 41b attached to a rotation shaft of the motor 42, and a belt 41c stretched between the driven pulley 41a and the driving pulley 41b.

Thus, the rotation shaft 35 is rotatable about the vertical axis J together with the ambient shield plate 30 by a rotative driving force from the motor 42. Therefore, the ambient shield plate 30 is rotated coaxially with the spin base 10 and the wafer W held by the spin base 10. The ambient shield plate 30 is rotated at substantially the same rotation speed as the wafer W held by the spin base 10. The belt drive mechanism 41 is housed within the support arm 40.

The support arm 40 is connected to an arm lift mechanism 49 for up and down movement thereof. Thus, the treatment liquid supplying section 7 is movable between a proximate position at which it is located just above the wafer W held by the spin base 10 and a retracted position at which it is retracted apart from the wafer W held by the spin base 10. In Fig. 1, the treatment liquid supplying section 7 is located at the retracted position.

The treatment liquid pipe 36 has an open lower end serving as a treatment liquid ejection port 36a, and an upper end connected to one end of a treatment liquid supply pipe 37. The other end of the treatment liquid supply pipe 37 is branched into a branch pipe 37a and a branch pipe 37b. A pure water supply source 17a for supplying pure water is connected in communication with the branch pipe 37a, and an etching liquid supply source 17b is connected in communication with the branch pipe 37b. The etching liquid supply source 17b supplies a solution mixture of hydrofluoric acid and hydrochloric acid as the etching liquid.

Valves 38a and 38b are provided in the midst of the branch pipes 37a and 37b, respectively. By opening and closing the valves 38a, 38b, the etching liquid and the pure water are selectively ejected from the treatment liquid ejection port 36a of the treatment liquid pipe 36. That is, the pure water can be supplied from the treatment liquid ejection port 36a by opening the valve 38a and closing the valve 38b. The etching liquid can be supplied from the treatment liquid ejection port 36a by opening the valve 38b and closing the valve 38a.

A gap is present between an interior surface of the rotation shaft 35 and the treatment liquid pipe 36. This gap serves as a gas supply path 45. The gas supply path 45 has a lower end serving as a gas ejection port 45a and an upper end connected in communication with one end of a gas pipe 46. The other end of the gas pipe 46 is connected in communication with an inert gas supply source 23. The inert gas supply source 23 supplies nitrogen gas. A valve 47 is provided in the midst of the gas pipe 46. By opening the valve 47, the nitrogen gas can be supplied from the gas ejection port 45a.

The bi-fluid nozzle 68 is movably provided between the spin base 10 and the ambient shield plate 30. The bi-fluid nozzle 68 is coupled to a nozzle movement mechanism 65 via a link member 66. The link member 66 is bent upward so as not to interfere with the splash guard 50 when the splash guard 50 is moved up. The nozzle movement mechanism 65 includes a motor 65a having a vertical rotation shaft P, and is capable of rotating the link member 66 and the bi-fluid nozzle 68 connected to the link member 66 about the rotation shaft P.

Thus, the bi-fluid nozzle 68 is movable between an opposed position at which it is opposed to the wafer W held by the spin base 10 and a retracted position at which it is retracted laterally from the opposed position. At the opposed position, the bi-fluid nozzle 68 can be opposed to any portion from the center to the periphery of the wafer W held by the spin base 10. The nozzle movement mechanism 65 is connected to a nozzle lift mechanism 69, so that the bi-fluid nozzle 68 can be moved up and down together with the nozzle movement mechanism 65. Thus, the bi-fluid nozzle 68 is movable between the retracted position and the opposed position without interference with the splash guard 50 even when the splash guard 50 is moved up.

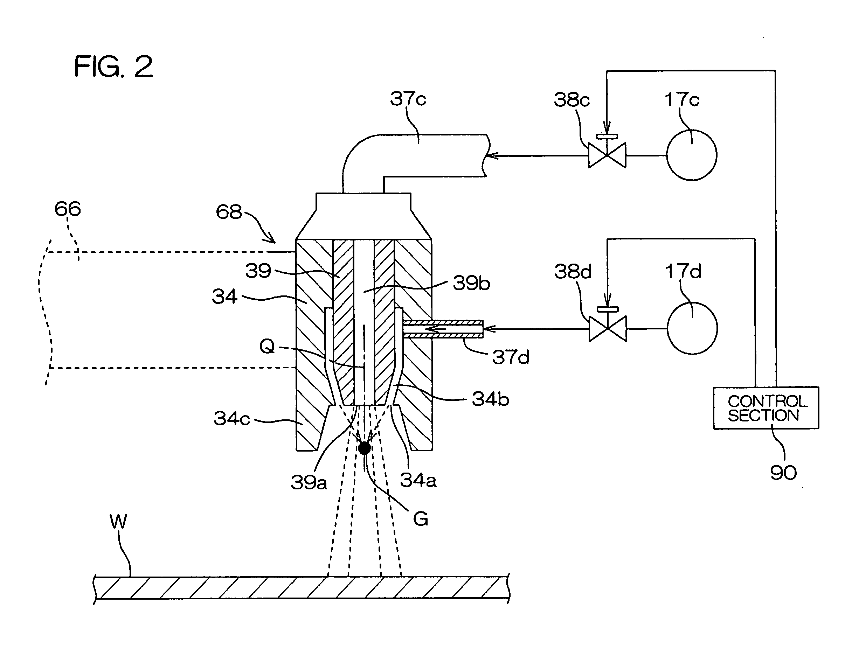

Fig. 2 is a schematic sectional view illustrating the construction of the bi-fluid nozzle 68.

The bi-fluid nozzle 68 includes a tubular liquid nozzle 39 and a tubular gas nozzle 34 surrounding the liquid nozzle 39, and has a generally cylindrical outer shape. The liquid nozzle 39 and the gas nozzle 34 have a common center axis Q and are coaxially positioned. An annular projection 34c is provided at one end of the gas nozzle 34 as projecting axially from the liquid nozzle 39. An inside portion of the liquid nozzle 39 serves as a liquid supply channel 39b. An annular space having the center axis Q is defined between the liquid nozzle 39 and the gas nozzle 34, and serves as a gas supply channel 34b.

The gas supply channel 34b has an open end serving as a gas ejection port 34a on the side of the annular projection 34c of the bi-fluid nozzle 68. The gas supply channel 34b has a generally uniform diameter in an axially middle portion of the bi-fluid nozzle 68, but in the vicinity of the gas ejection port 34a, has a diameter decreasing toward the annular projection 34c so as to be convergent on a convergence point G which is located a predetermined distance apart from the gas ejection port 34a. The liquid supply channel 39b has an open end serving as a liquid ejection port 39a at the center of the gas ejection port 34a. In the substrate treatment apparatus 1, the bi-fluid nozzle 68 is provided so that the liquid ejection port 39a and the gas ejection port 34a are directed downward.

One end of a pretreatment liquid supply pipe 37c is connected to an end of the bi-fluid nozzle 68 opposite from the annular projection 34c in communication with the liquid nozzle 39. The other end of the pretreatment liquid supply pipe 37c is connected to a pretreatment liquid supply source 17c. The pretreatment liquid supply source 17c supplies a solution mixture of ammonia, hydrogen peroxide and water as the pretreatment liquid. One end of a compressed air supply pipe 37d is connected to a generally middle portion of a side wall of the bi-fluid nozzle 68 as seen along the center axis Q. An inside space of the compressed air supply pipe 37d communicates with the gas supply channel 34b. The other end of the compressed air supply pipe 37d is connected to a compressed air supply source 17d.

A valve 38c is provided in the midst of the pretreatment liquid supply pipe 37c so as to control the opening and closing of the flow path of the pretreatment liquid and the flow rate of the pretreatment liquid. A valve 38d is provided in the midst of the compressed air supply pipe 37d so as to control the opening and closing of the flow path of the compressed air and the flow rate of the compressed air.

When the pretreatment liquid is supplied from the pretreatment liquid supply pipe 37c to the bi-fluid nozzle 68, the pretreatment liquid is ejected from the liquid ejection port 39a. When the compressed air is supplied from the compressed air supply pipe 37d to the bi-fluid nozzle 68, the compressed air is ejected from the gas ejection port 34a. The ejected pretreatment liquid travels generally straight, while the compressed air annularly ejected travels as converging on the convergence point G. When the pretreatment liquid and the compressed air are simultaneously supplied, the compressed air collides against the pretreatment liquid at the convergence point G. Thus, the pretreatment liquid is mixed with the compressed air thereby to be disintegrated into liquid droplets, which travel ahead while diverging slightly. That is, a jet of the droplets of the pretreatment liquid is provided.

Referring to Figs. 1 and 2, the operations of the motors 20, 42, the arm lift mechanism 49, the guard lift mechanism 55, the nozzle movement mechanism 65, the nozzle lift mechanism 69, the valves 38a to 38d and 47, and the like are controlled by the control section 90.

A method for cleaning the surface of the wafer W by means of the substrate treatment apparatus 1 will hereinafter be described.

First, the guard lift mechanism 55 is controlled by the control section 90 so that an upper end of the splash guard 50 is generally leveled off at the spin base 10. Further, the nozzle movement mechanism 65 and the arm lift mechanism 49 are controlled by the control section 90 to move the bi-fluid nozzle 68 and the treatment liquid supplying section 7 to the retracted positions. In this state, a wafer W is transported onto the spin base 10 by a transportation robot not shown, and the chuck pins 14 are turned into the pressing state. Thus, the wafer W is held horizontally on the spin base 10 so that a surface thereof to be subjected to a cleaning process faces upward.

Subsequently, the nozzle movement mechanism 65 is controlled by the control section 90 to locate the bi-fluid nozzle 68 at the opposed position. Then, the guard lift mechanism 55 is controlled by the control section 90 to move up the splash guard 50 to a vertical position such that the spin base 10 and the wafer W held by the spin base 10 are laterally surrounded by the second guide 52. This state is shown in Fig. 1.

Thereafter, the motor 20 is rotated by the control section 90, whereby the wafer W held by the spin base 10 is rotated. Further, the valves 38c, 38d are opened by the control section 90, whereby the pretreatment liquid and the compressed air are introduced into the bi-fluid nozzle 68. Thus, the droplets of the pretreatment liquid are generated and sprayed onto the surface of the wafer W.

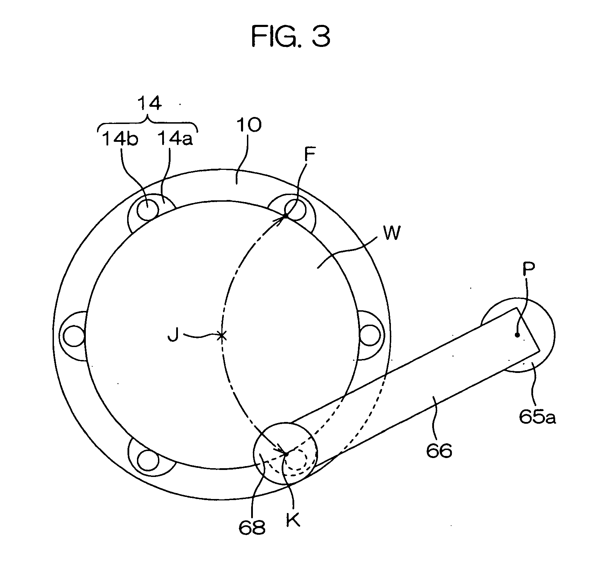

Fig. 3 is a schematic plan view for explaining the action of the bi-fluid nozzle 68 relative to the wafer W held by the spin base 10 in the pretreatment process.

The bi-fluid nozzle 68 is moved along an arcuate path about the rotation shaft P of the motor 65a. The droplets of the pretreatment liquid are ejected toward the surface of the rotated wafer W, while the bi-fluid nozzle 68 is moved from a starting point K through the axis J to a final point F, wherein the starting point K is one of intersections between the arcuate path and the periphery of the wafer W, the axis J is the center and rotation center of the wafer W and the final point F is the other intersection. Thus, the entire surface of the wafer W is uniformly treated.

The droplets of the pretreatment liquid can be bombarded against the surface of the wafer W with a great kinetic energy by introducing the high-pressure compressed air into the bi-fluid nozzle 68. At this time, particles adhering on the surface of the wafer W are physically removed by the kinetic energy of the droplets of the pretreatment liquid. The particles once removed from the surface of the wafer W do not easily adhere again onto the surface of the wafer W due to a repulsive force of a ζ potential. In addition, the pretreatment liquid is bombarded against the surface of the wafer W in a liquid droplet form (atomized form), so that the wafer W per se is not subjected to an excessively great load. Even if a pattern is formed on the surface of the wafer W, there is no possibility that the pattern is damaged. Further, the removal of the particles can be achieved in a shorter time by the physical cleaning.

The surface of the wafer W is oxidized by the aforesaid solution mixture of ammonia, hydrogen peroxide and water as the pretreatment liquid. By properly adjusting the period of the pretreatment with the pretreatment liquid and the concentrations of the effective components of the pretreatment liquid, the thickness of an oxide layer to be formed on the surface of the wafer W can be controlled. Thus, the pretreatment process for the wafer W is achieved. By properly determining the composition of the pretreatment liquid, the surface of the wafer W can shallowly be oxidized in a shorter time.

Further, copper (Cu) deposited as a metal deposit on the surface of the wafer W is dissolved in the form of an ammine complex by ammonia (aqueous ammonia) contained in the pretreatment liquid.

The pretreatment liquid on the wafer W is spun off laterally of the wafer W by a centrifugal force, and received by the second guide 52 of the splash guard 50 (Fig. 1). Then, the pretreatment liquid flows down into the second drain chamber 29, and discharged into the recovery drain 29b through the drain port 29a. The pretreatment liquid discharged from the recovery drain 29b is collected in a recovery tank (not shown), and then supplied to the pretreatment liquid supply source 17c. Thus, the pretreatment liquid is recycled.

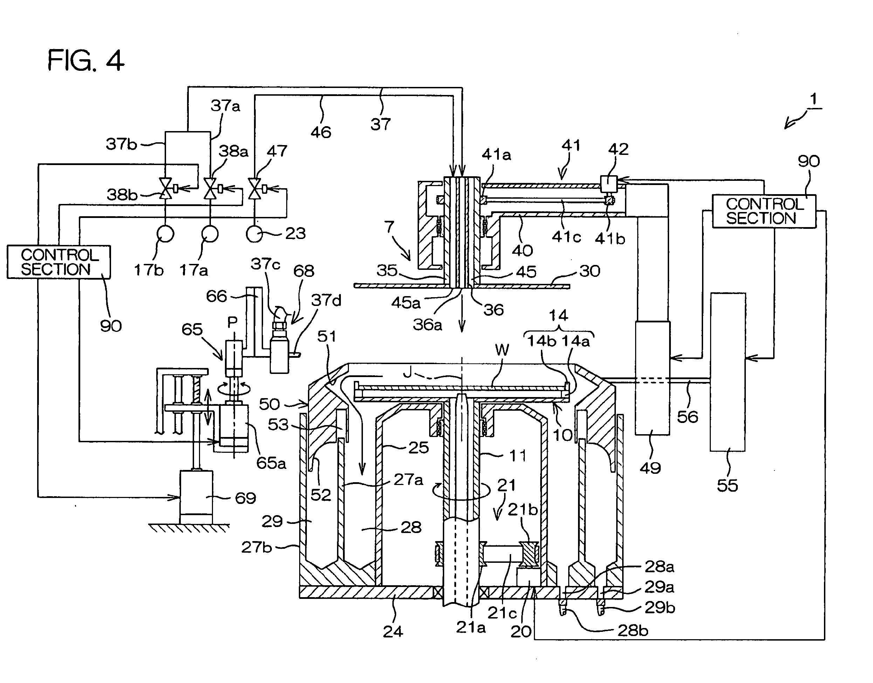

Fig. 4 is a schematic sectional view illustrating a state of the substrate treatment apparatus 1 shown in Fig. 1 in an etching process.

After the pretreatment process, the etching process is performed. First, the guard lift mechanism 55 is controlled by the control section 90 to move down the splash guard 50 so that the spin base 10 and the wafer W held by the spin base 10 are surrounded by the first guide 51. Then, the nozzle movement mechanism 65 and the nozzle lift mechanism 69 are controlled by the control section 90 so that the bi-fluid nozzle is retracted to the retracted position. In this state (with the treatment liquid supplying section 7 located at the retracted position), the valve 38b is opened by the control section 90, so that the etching liquid is supplied to a center portion of the upper surface of the wafer W from the treatment liquid ejection port 36a.

The surface layer of the wafer W oxidized with the pretreatment liquid is selectively etched with the solution mixture of hydrofluoric acid and hydrochloric acid as the etching liquid. The etching liquid containing hydrochloric acid in addition to hydrofluoric acid has a greater capability of dissolving the metal deposit. Therefore, metals deposited on the surface of the wafer W can advantageously be removed.

The etching liquid is spun off from the wafer W by a centrifugal force, received by the first guide 51 of the splash guard 50, and then flows down into the first drain chamber 28. The etching liquid collected in the first drain chamber 28 is discharged into the waste drain 28b from the drain port 28a, and then discarded.

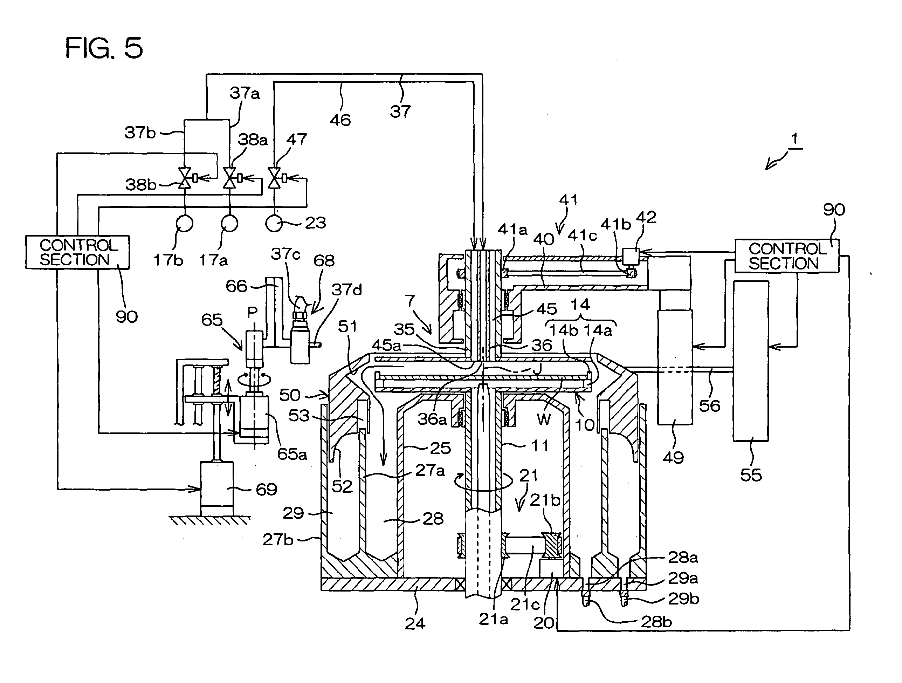

After the etching process, a water rinsing process and a drying process are performed. Fig. 5 is a schematic sectional view illustrating a state of the substrate treatment apparatus 1 shown in Fig. 1 in the water rinsing process and the drying process.

After the etching liquid is supplied to the wafer W for a predetermined period, the valve 38b is closed by the control section 90 to stop the supply of the etching liquid. Then, the arm lift mechanism 49 and the motor 42 are controlled by the control section 90, so that the ambient shield plate 30 is positioned at the proximate position and rotated. In this state, the valves 38a and 47 are controlled to be opened by the control section 90. Thus, the pure water is supplied onto the surface of the wafer W from the treatment liquid ejection port 36a to rinse away the etching liquid. At this time, the nitrogen gas is supplied from the gas ejection port 45a, so that an oxygen partial pressure in a space between the ambient shield plate 30 and the wafer W is reduced.

The water is spun off from the wafer W by a centrifugal force, received by the first guide 51 of the splash guard 50, and then flows down into the first drain chamber 28. The water collected in the first drain chamber 28 is discharged into the waste drain 28b from the drain port 28a, and then discarded.

After the pure water is supplied to the wafer W for a predetermined period, the valve 38a is controlled to be closed by the control section 90, so that the supply of the pure water is stopped. However, the supply of the nitrogen gas from the gas ejection port 45a is continued. Thus, the water is spun off from the surface of the wafer W for drying, while the space between the ambient shield plate 30 and the wafer W is kept at a reduced oxygen partial pressure. Upon completion of the drying of the surface of the wafer W, the valve 47 and the arm lift mechanism 49 are controlled by the control section 90 so as to stop the supply of the nitrogen gas and retract the treatment liquid supplying section 7 to the retracted position. The guard lift mechanism 55 is controlled by the control section 90, so that the upper end of the splash guard 50 is generally leveled off at the spin base 10. Then, the chuck pins 14 are turned into the non-pressing state, and the treated wafer W is transported out by the transportation robot not shown. Thus, the treatment of the surface of the single wafer W is completed.

During the aforesaid process sequence, the pretreatment liquid and the etching liquid may be kept at an ordinary temperature, i.e., 20 to 28°C, preferably 20 to 25°C. That is, if the room is kept at an ordinary temperature, there is no particular need to adjust the temperatures of the pretreatment liquid and the etching liquid. Therefore, the treatment of the substrate can easily be performed.

In the aforesaid wafer surface cleaning method, the etching liquid has a sufficiently great capability of dissolving the deposited metals, so that the substrate surface etch amount can be reduced.

By properly determining the composition of the etching liquid, the deposited metals can be etched away in a shorter time. Therefore, the cleaning process from the removal of the particles to the removal of the deposited metals can be performed in a shorter time.

The present invention is not limited to the embodiment described above. For example, an inert gas such as nitrogen gas may be employed instead of the compressed air when the droplets of the pretreatment liquid are generated by means of the bi-fluid nozzle 68.

In the embodiment described above, the gas (compressed air) is blown on the pretreatment liquid in an open space for the generation of the droplets of the pretreatment liquid (external mixing), but a bi-fluid nozzle of an internal mixing type may be employed which is adapted to provide a jet of liquid droplets by mixing the pretreatment liquid with the gas within the nozzle.

The pretreatment liquid supply source 17c (see Fig. 2) may be adapted to supply a solution mixture containing ammonia and ozone water as the pretreatment liquid. With the use of such a pretreatment liquid, the surface of the wafer W can be oxidized to a proper thickness, and copper as the metal deposit can be dissolved in the form of an ammine complex.

Further, the water rinsing process for rinsing the surface of the wafer W with pure water may also be performed between the pretreatment process and the etching process.

### Example 1

A wafer cleaning test was performed with the use of the aforesaid substrate treatment apparatus 1.

A solution mixture obtained by mixing an aqueous ammonia solution (29% solution), an aqueous hydrogen peroxide solution (30% solution) and water in a volume ratio of 1:1:5 was employed as the pretreatment liquid. A solution mixture obtained by mixing an aqueous hydrofluoric acid solution (50% solution), an aqueous hydrochloric acid solution (35% solution) and water in a volume ratio of 1:42:210 was employed as the etching liquid. During the process, the pretreatment liquid and the etching liquid each had a temperature of 23°C.

The distance between the liquid ejection port 39a of the bi-fluid nozzle 68 and the convergence point G was not greater than 20 mm, and the distance between the convergence point G and the wafer W was 3 to 30 mm. The flow rate of the compressed air introduced into the bi-fluid nozzle 68 was 50 to 100 l/min, and the flow rate of the pretreatment liquid introduced into the bi-fluid nozzle 68 was 100 to 150 ml/min. Droplets of the pretreatment liquid provided under such conditions each had a diameter of about 5 to about 20µm. Under the aforesaid conditions, the droplets of the pretreatment liquid were supplied (or the pretreatment liquid was sprayed) onto the surface of the wafer W, while the bi-fluid nozzle 68 was moved from the starting point K through the axis J to the final point F as shown in Fig. 3. At this time, the rotation speed of the spin base 10 (wafer W) was 10 to 1000 rpm.

Subsequently, the etching liquid was supplied onto the center of the wafer W from the treatment liquid ejection port 36a for etching, while nitrogen gas was ejected from the gas ejection port 45a. Thereafter, pure water was supplied onto the center of the wafer W from the treatment liquid ejection port 36a for 10 seconds to rinse away the etching liquid. Then, the supply of the pure water was stopped, and the water was spun off by the rotation of the wafer W for drying.

The time required for the aforesaid process sequence was sufficiently short, i.e., not longer than 100 seconds per wafer W.

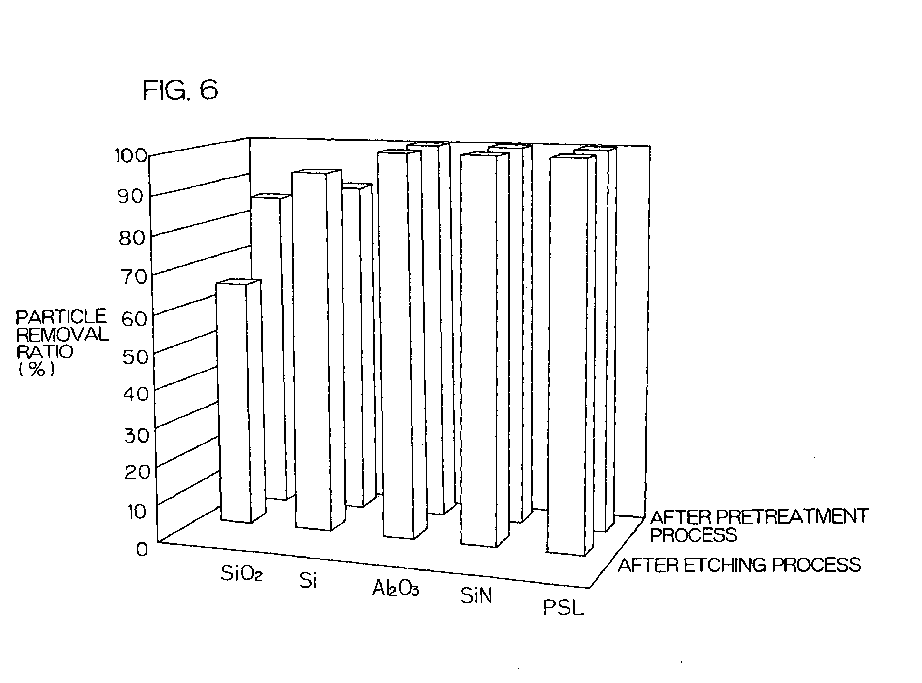

Fig. 6 is a diagram showing particle removal ratios at which particles of SiO₂, Si, Al₂O₃, SiN and PSL (resin) were removed from the surface of the wafer W after the pretreatment process and after the etching process. Except the SiO₂ particles, not lower than about 90% of the particles were removed. These particle removal ratios are comparable to those provided by the multiple-wafer batch cleaning process in which a plurality of wafers W are simultaneously immersed in the treatment liquid for cleaning.

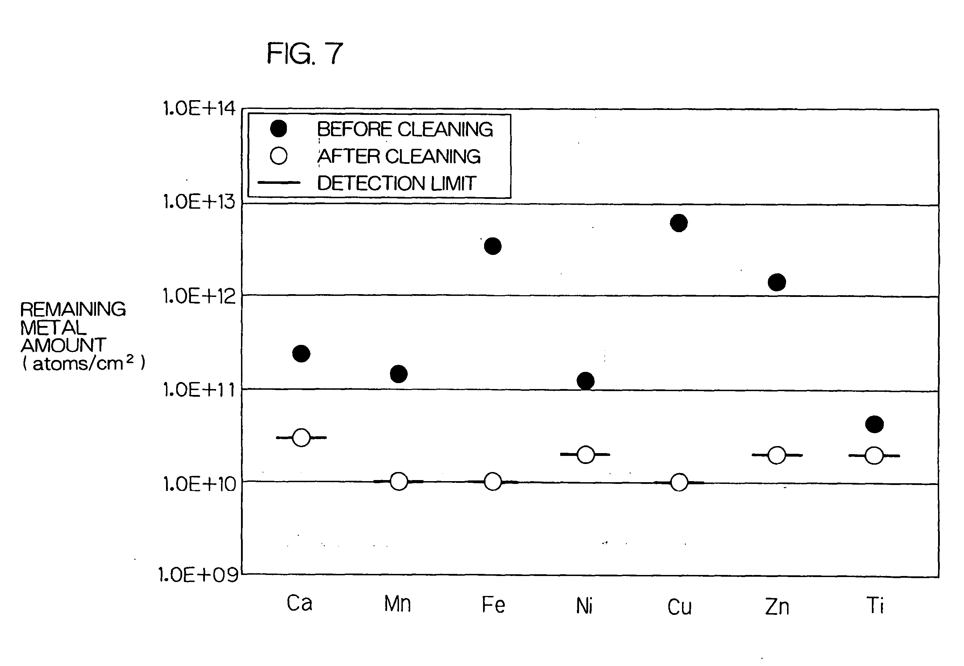

Fig. 7 is a diagram showing the amounts of metals (Ca, Mn, Fe, Ni, Cu, Zn and Ti) deposited on the surface of the wafer W before and after the cleaning process. The analysis of the deposited metals was performed by employing a total reflection X-ray fluorescence analyzer (ditto in the following examples). The amounts of the deposited metals were 10¹⁰ to 10¹³ atoms/cm² before the cleaning process, but reduced below a detection limit (not greater than the order of 10¹⁰ atoms/cm²) after the cleaning process. The deposited metal amounts after the cleaning process were comparable to those provided by the multiple-wafer batch cleaning process.

Even where the mixing ratio of the total of the aqueous hydrochloric acid solution having the aforesaid concentration and the water was 50 to 1000 parts by volume based on 1 part by volume of the aqueous hydrofluoric acid solution having the aforesaid concentration and the mixing ratio of the water was 3 to 15 parts by volume based on 1 part by volume of the aqueous hydrochloric acid solution having the aforesaid concentration in the etching liquid, a comparable cleaning effect was provided. Where only the aqueous hydrofluoric acid solution was employed as the etching liquid, the etch thickness was about 8 to about 9Å. However, the etch thickness was reduced to about 2 Å where the solution mixture containing hydrofluoric acid and hydrochloric acid was employed as the etching liquid as described above.

### Example 2

A variation in the wafer cleaning effect depending on the composition of the pretreatment liquid was checked with the use of the aforesaid substrate treatment apparatus 1.

A wafer W employed in this cleaning test had a diameter of 8 inches, and was formed with a 200-nm (2000-Å) thick thermal oxide film (bare-Si), on which various kinds of metals (Ca, Mn, Fe, Ni, Cu, Zn and Ti) were forcibly deposited in an amount of about 4×10¹⁰ to about 1×10¹⁴ atoms/cm² and various kinds of particles (PSL, SiN, Al₂O₃, Si and SiO₂) were forcibly deposited in an amount of about 5000 to about 10000 particles.

Three solution mixtures obtained by mixing an aqueous ammonia solution (29% solution), an aqueous hydrogen peroxide solution (30% solution) and water in volume ratios of 1:1:50, 1:1:20 and 1:1:5, respectively, were employed as the pretreatment liquid. A solution mixture obtained by mixing an aqueous hydrofluoric acid solution (50% solution), an aqueous hydrochloric acid solution (35% solution) and water in a volume ratio of 1:41:207 was employed as the etching liquid. During the process, the pretreatment liquid and the etching liquid each had a temperature of 23°C.

First, the pretreatment process was performed on the wafer W by the bi-fluid nozzle 68. The same conditions as in Example 1 were employed for the pretreatment process performed by the bi-fluid nozzle 68. The time spent for moving the bi-fluid nozzle 68 from the starting point K through the axis J to the final point F, i.e., the pretreatment period, was 20 seconds. Subsequently, pure water was ejected from the treatment liquid ejection port 36a for 20 seconds for rinsing the wafer W with the pure water (intermediate water rinsing) . Then, the wafer W was subjected to the etching process. The time spent for supplying the etching liquid onto the wafer W from the treatment liquid ejection port 36a, i.e., the etching period, was 20 seconds.

Thereafter, pure water was supplied onto the center of the wafer W from the treatment liquid ejection port 36a for 40 seconds for rinsing the wafer W with the pure water. Then, the supply of the pure water was stopped, and the water was spun off for 20 seconds by rotating the wafer W for drying.

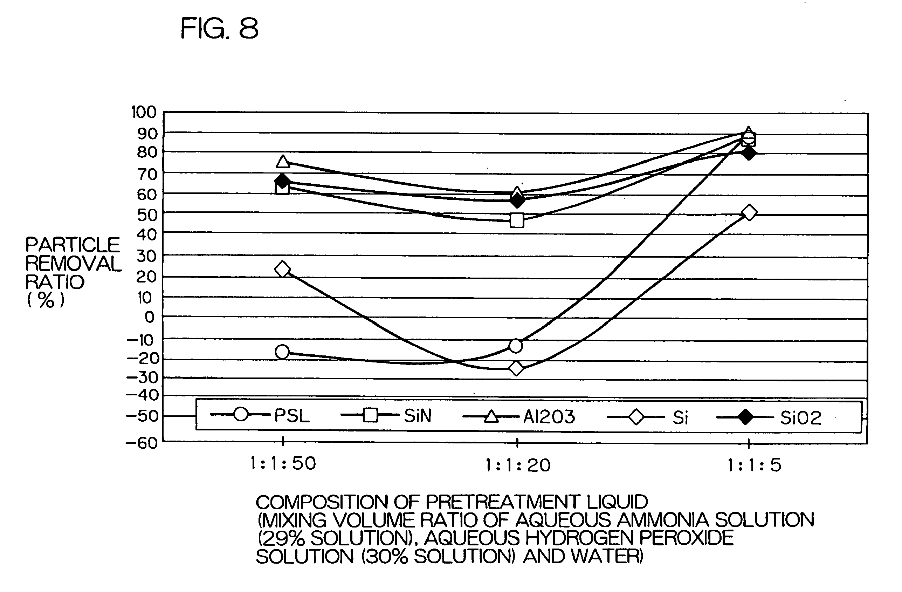

Fig. 8 is a diagram showing particle removal ratios at which particles of PSL, SiN, Al₂O₃, Si and SiO₂ were removed from surfaces of wafers W after the cleaning process was performed by employing the pretreatment liquids having different compositions. When the pretreatment liquid obtained by mixing the aqueous ammonia solution (29% solution), the aqueous hydrogen peroxide solution (30% solution) and water in a volume ratio of 1:1:5 was employed, the respective kinds of particles were removed at the highest removal ratios. The removal ratios of the PSL particles and the Si particles were particularly high as compared with the cases where the pretreatment liquids obtained by mixing the aqueous ammonia solution (29% solution), the aqueous hydrogen peroxide solution (30% solution) and water in volume ratios of 1:1:50 and 1:1:20, respectively, were employed.

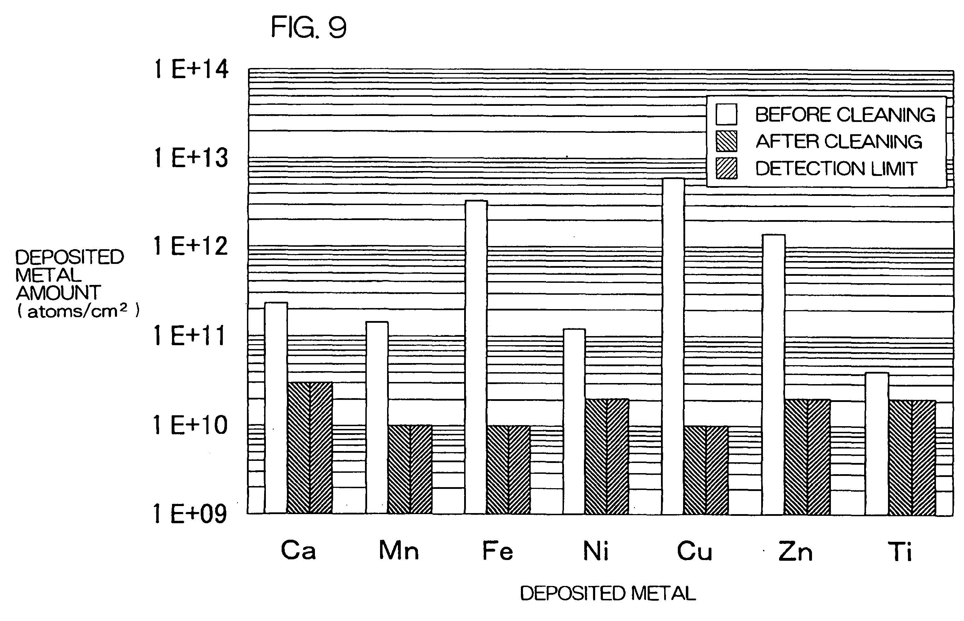

Fig. 9 is a diagram showing the amounts of metals (Ca, Mn, Fe, Ni, Cu, Zn and Ti) deposited on the surface of the wafer W after the cleaning process when the pretreatment liquid obtained by mixing the aqueous ammonia solution (29% solution), the aqueous hydrogen peroxide solution (30% solution) and water in a volume ratio of 1:1:5 was employed for the pretreatment process.

The amounts of the respective kinds of deposited metals were reduced below the detection limit (on the order of 1×10¹⁰) after the cleaning process.

### Example 3

A variation in the wafer cleaning effect depending on the pretreatment period was checked with the use of the aforesaid substrate treatment apparatus 1.

A solution mixture obtained by mixing an aqueous ammonia solution (29% solution), an aqueous hydrogen peroxide solution (30% solution) and water in a volume ratio of 1:1:5 was employed as the pretreatment liquid. A solution mixture obtained by mixing an aqueous hydrofluoric acid solution (50% solution), an aqueous hydrochloric acid solution (35% solution) and water in a volume ratio of 1:41:207 was employed as the etching liquid. During the process, the pretreatment liquid and the etching liquid each had a temperature of 23°C.

First, the pretreatment process was performed on the wafer W by the bi-fluid nozzle 68. The same conditions as in Example 1 were employed for the pretreatment process performed by the bi-fluid nozzle 68. However, five pretreatment periods, i.e., 5 seconds, 10 seconds, 15 seconds, 20 seconds and 30 seconds, were employed. Then, the wafer W was subjected to the etching process. The etching period was 20 seconds.

Thereafter, the wafer W was rinsed with pure water for 30 seconds. Then, the supply of the pure water was stopped, and the water was spun off for 20 seconds by rotating the wafer W for drying.

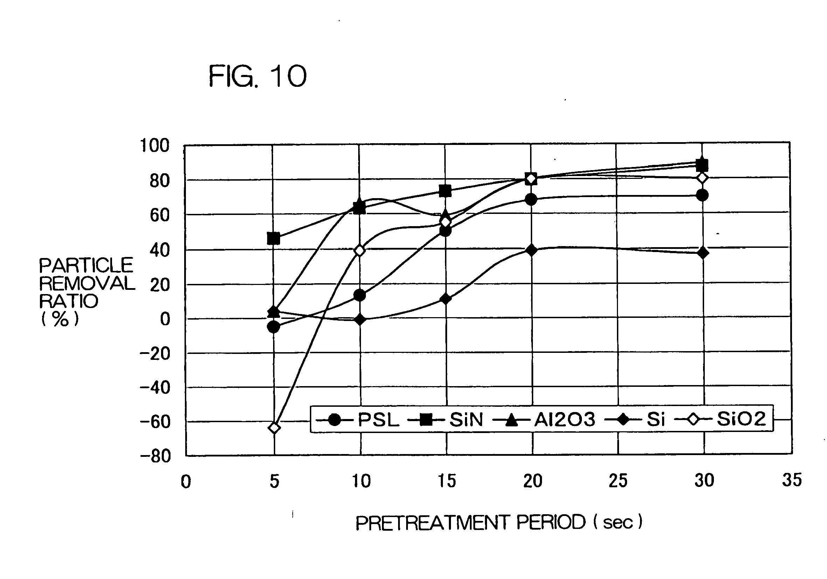

Fig. 10 is a diagram showing relationships between the pretreatment period and the particle removal ratio at which particles were removed from the surface of the wafer W. For the removal of any of the various kinds of particles, the removal ratio was generally increased with the pretreatment period, and was at a plateau when the pretreatment period was 20 seconds or longer. As can be understood from the results, the pretreatment process can be completed in a pretreatment period of 20 seconds.

### Example 4

A variation in the wafer cleaning effect depending on the composition of the etching liquid and the etching period was checked with the use of the aforesaid substrate treatment apparatus 1.

A solution mixture obtained by mixing an aqueous ammonia solution (29% solution), an aqueous hydrogen peroxide solution (30% solution) and water in a volume ratio of 1:1:5 was employed as the pretreatment liquid. Three solution mixtures obtained by mixing an aqueous hydrofluoric acid solution (50% solution), an aqueous hydrochloric acid solution (35% solution) and water in a volume ratio of 0.5:41:207, 1:41:207 and 2:41:207 (hereinafter referred to as "0.5:41:207 solution", "1:41:207 solution" and "2:41:207 solution", respectively) were employed as the etching liquid. During the process, the pretreatment liquid and the etching liquid each had a temperature of 23°C.

First, the pretreatment process was performed on the wafer W for 20 seconds by the bi-fluid nozzle 68. The same conditions as in Example 1 were employed for the pretreatment process performed by the bi-fluid nozzle 68. Then, the etching process was performed on the wafer W with the use of the etching liquid. For the etching with the 0.5:41:207 solution, two etching periods, i.e., 20 seconds and 40 seconds, were employed. For the etching with the 1:41:207 solution, two etching periods, i.e., 10 seconds and 20 seconds, were employed. For the etching with the 2:41:207 solution, three etching periods, i.e., 5 seconds, 10 seconds and 20 seconds, were employed.

Thereafter, the wafer W was rinsed with pure water for 30 seconds. Then, the supply of the pure water was stopped, and the water was spun off for 20 seconds by rotating the wafer W for drying.

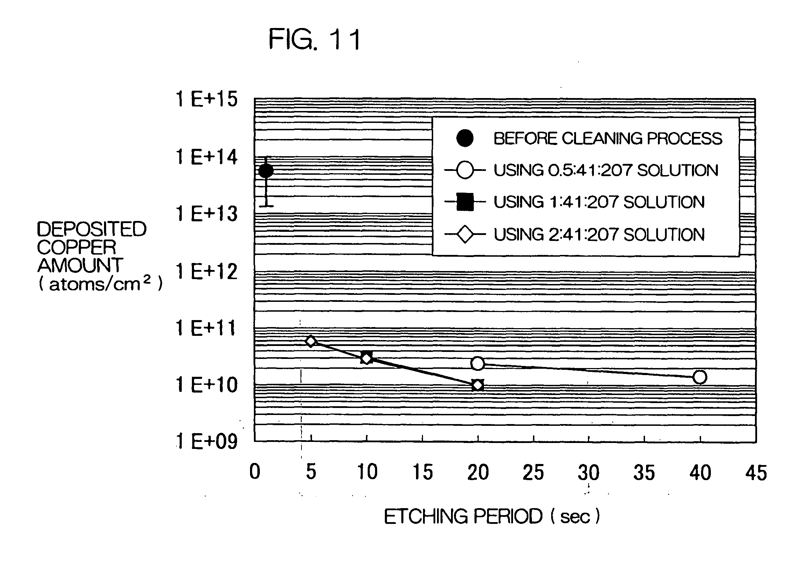

Fig. 11 is a diagram showing the amounts of copper deposited on the surface of the wafer W before and after the cleaning process was performed with the respective etching periods.

The deposited copper amount was about 10¹³ to about 10¹⁴ atoms/cm² before the cleaning process, but reduced as the etching period was increased. Where the 1:41:207 solution and the 2:41:207 solution were employed as the etching liquid, the deposited copper amount was sufficiently reduced to about 10¹⁰ atoms/cm² with an etching period of 20 seconds. Where the 0.5:41:207 solution was employed as the etching liquid, the deposited copper amount was sufficiently reduced to about 10¹⁰ atoms/cm² with an etching period of 40 seconds. As can be understood from the results, the etching process can be completed in an etching period of 20 seconds where the 1:41:207 solution was employed.

### Example 5

A relationship between the wafer etching period and the etch thickness was checked with the use of the aforesaid substrate treatment apparatus 1. The wafer W was not subjected to the pretreatment process prior to the etching process. A 1:41:207 solution was employed as the etching liquid. During the process, the etching liquid had a temperature of 23°C. Five etching periods, i.e., 8 seconds, 10 seconds, 15 seconds, 20 seconds and 25 seconds, were employed for the etching process.

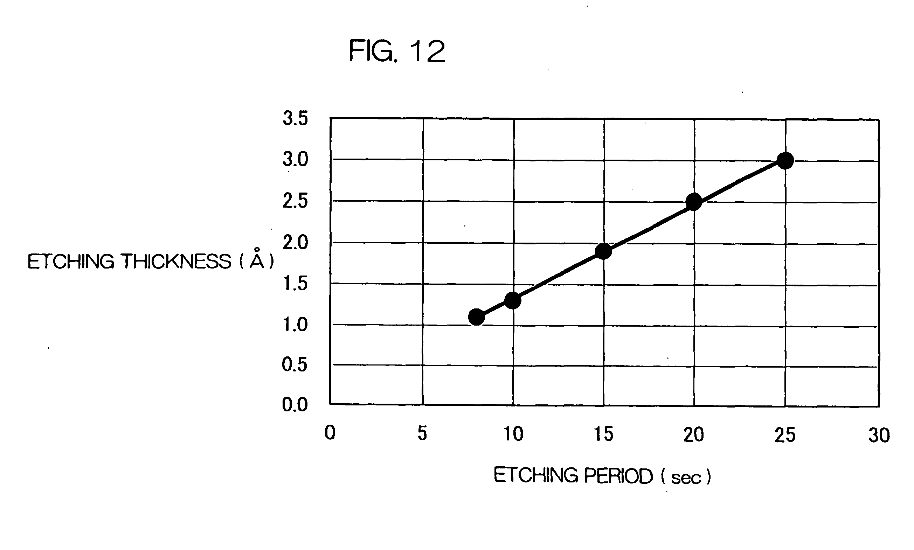

Fig. 12 is a diagram showing the relationship between the wafer etching period and the etch thickness. The etch thickness was generally linearly increased with the etching period. Where the etching period was 20 seconds, the etch thickness was suppressed to about 2.5Å.

### Example 6

A variation in the wafer cleaning effect depending on the water rinsing period was checked with the use of the aforesaid substrate treatment apparatus 1.

A solution mixture obtained by mixing an aqueous ammonia solution (29% solution), an aqueous hydrogen peroxide solution (30% solution) and water in a volume ratio of 1:1:5 was employed as the pretreatment liquid. A solution mixture obtained by mixing an aqueous hydrofluoric acid solution (50% solution), an aqueous hydrochloric acid solution (35% solution) and water in a volume ratio of 1:41:207 was employed as the etching liquid. During the process, the pretreatment liquid and the etching liquid each had a temperature of 23°C.

First, the pretreatment process was performed on the wafer W by the bi-fluid nozzle 68. The same conditions as in Example 1 were employed for the pretreatment process performed by the bi-fluid nozzle 68. The pretreatment period was 20 seconds. Then, the wafer W was subjected to the etching process. The etching period was 20 seconds.

Subsequently, the wafer W was rinsed with water. Four water rinsing periods, i.e., 0 second, 20 seconds, 30 seconds and 60 seconds, were employed for the water rinsing process. Thereafter, the water was spun off for 20 seconds by rotating the wafer W for drying.

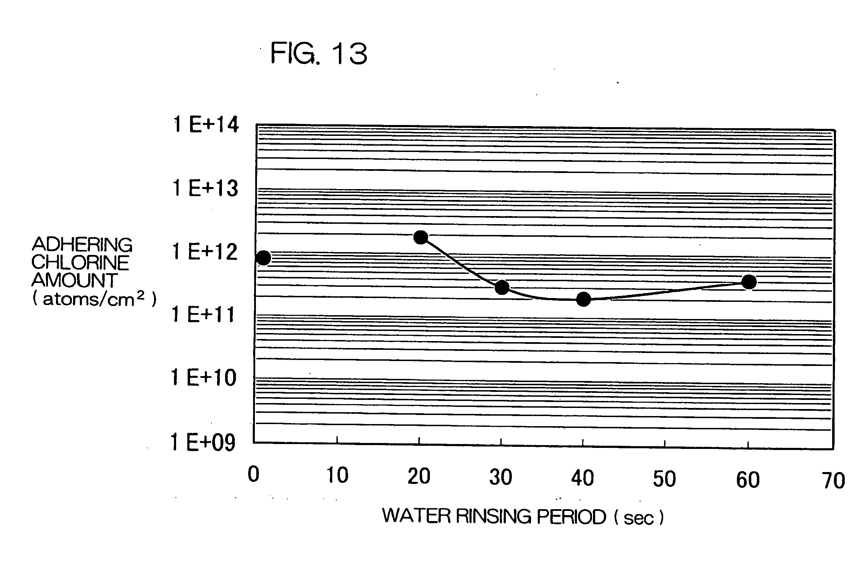

Then, the amount of chlorine remaining as a constituent of the etching liquid on the surface of the wafer W was measured to determine how much the etching liquid was removed from the wafer W by the water rinsing. Fig. 13 is a diagram showing the amounts of chlorine on the surface of the wafer W after the cleaning process was performed with the respective water rinsing periods. The chlorine detection limit was about 2.0×10¹¹ atoms/cm².

The chlorine amount was about 8×10¹¹ atoms/cm² when the water rinsing process was not performed after the etching process, and generally reduced as the water rinsing period was increased. Where the water rinsing period was 30 seconds or longer, the chlorine amount was not greater than about 4×10¹¹ atoms/cm². This is comparable to a chlorine amount (about 3×10¹¹ atoms/cm²) observed after the wafer W is rinsed with water by the multiple-wafer batch process.

In Examples 3, 4 and 6, the intermediate water rinsing process was not performed after the pretreatment process before the etching process, but the deposited metal amounts and the particle amounts after the cleaning process were sufficiently low. This indicates that the intermediate water rinsing process may be obviated.

In Examples 2 to 6, the cleaning test was performed with the use of wafers W on which the metals and the particles were forcibly deposited, and optimum cleaning conditions for a naturally contaminated wafer W may be different from the aforesaid conditions. However, the cleaning conditions may be changed within wide ranges of conditions specified by the present invention, so that the naturally contaminated wafer W can also properly be cleaned by changing the cleaning conditions depending on the kinds and amounts of metals and particles deposited on the wafer.

### Example 7

A wafer cleaning test was performed with the use of the aforesaid substrate treatment apparatus 1.

A solution mixture obtained by mixing an aqueous ammonia solution (29% solution) and ozone water having an ozone concentration of 5 to 30 ppm in a volume ratio of 1:5 was employed as the pretreatment liquid. A solution mixture obtained by mixing an aqueous hydrofluoric acid solution (50% solution), an aqueous hydrochloric acid solution (35% solution) and water in a volume ratio of 1:42:210 was employed as the etching liquid. During the process, the pretreatment liquid and the etching liquid each had a temperature of 23°C.

The distance between the liquid ejection port 39a of the bi-fluid nozzle 68 and the convergence point G was not greater than 20 mm, and the distance between the convergence point G and the wafer W was 3 to 30 mm. The flow rate of the compressed air introduced into the bi-fluid nozzle 68 was 50 to 100 l/min, and the flow rate of the pretreatment liquid introduced into the bi-fluid nozzle 68 was 100 to 150 ml/min. Droplets of the pretreatment liquid provided under such conditions each had a diameter of about 5 to about 20µm. Under the aforesaid conditions, the droplets of the pretreatment liquid were supplied (or the pretreatment liquid was sprayed) onto the surface of the wafer W, while the bi-fluid nozzle 68 was moved from the starting point K through the axis J to the final point F as shown in Fig. 3. At this time, the rotation speed of the spin base 10 (wafer W) was 10 to 1000 rpm.

Subsequently, the etching liquid was supplied onto the center of the wafer W from the treatment liquid ejection port 36a for etching, while nitrogen gas was ejected from the gas ejection port 45a. Thereafter, pure water was supplied onto the center of the wafer W from the treatment liquid ejection port 36a for 10 seconds to rinse away the etching liquid. Then, the supply of the pure water was stopped, and the water was spun off by the rotation of the wafer W for drying.

Even where the mixing ratio of the total of the aqueous hydrochloric acid solution having the aforesaid concentration and the water was 50 to 1000 parts by volume based on 1 part by volume of the aqueous hydrofluoric acid solution having the aforesaid concentration and the mixing ratio of the water was 3 to 15 parts by volume based on 1 part by volume of the aqueous hydrochloric acid solution having the aforesaid concentration in the etching liquid, a comparable cleaning effect was provided. An etch thickness observed when the solution mixture obtained by mixing hydrofluoric acid and hydrochloric acid was employed as the etching liquid as described above was smaller than an etch thickness observed when the aqueous hydrofluoric acid solution alone was employed as the etching liquid.

While the present invention has thus been described in detail by way of the embodiment thereof, it should be understood that the foregoing disclosure is merely illustrative of the technical principles of the present invention but not limitative of the same. The scope of the present invention is to be limited only by the appended claims.

The features disclosed in the foregoing description, in the claims and/or in the accompanying drawings may, both separately and in any combination thereof, be material for realising the invention in diverse forms thereof.

## Claims

1. A substrate treatment apparatus (1) comprising:
a pretreatment means (68) for bombarding liquid droplets against a surface of a substrate (W), the liquid droplets being generated by mixing a pretreatment liquid comprising ammonia and an oxidizing agent with a gas;
an etching liquid supplying means (7) for supplying an etching liquid onto the substrate (W) surface; and
a control section (90) for causing the pretreatment means (68) to bombard the liquid droplets against the surface of the substrate (W), and thereafter causing the etching liquid supplying means (7) to supply the etching liquid onto the substrate (W) surface.

2. A substrate treatment apparatus as set forth in claim 1, wherein the oxidizing agent is hydrogen peroxide.

3. A substrate treatment apparatus as set forth in claim 2, wherein the pretreatment liquid further comprises water.

4. A substrate treatment apparatus as set forth in claim 3, wherein the pretreatment liquid comprises 0,05 and 1 part by volume of aqueous ammonia, 0,1 to 1 part by volume of hydrogen peroxide, and 5 parts by volume of water.

5. A substrate treatment apparatus as set forth in claim 1, wherein the oxidizing agent is ozone water.

6. A substrate treatment apparatus as set forth in claim 5, wherein the pretreatment liquid is obtained by mixing 5 to 50 party by volume of ozone water having an ozone concentration of 5 to 30 ppm, and 1 part by volume of aqueous ammonia.

7. A substrate treatment apparatus as set forth in any of claims 1 to 6, wherein the pretreatment means (68) comprising a bi-fluid nozzle (68) including a pretreatment liquid ejecting means (39)for ejecting the pretreatment liquid, and a gas ejecting means (34) provided adjacent the pretreatment liquid means (39) for ejecting a gas, the bi-fluid nozzle (68) being capable of blowing the gas ejected from the gas ejecting means (34) on the pretreatment liquid ejected from the pretreatment liquid ejecting means (39) for the generation of the droplets of the pretreatment liquid and ejecting the liquid droplets onto the substrate (W) surface.

8. A substrate treatment apparatus as set forth in claim 7, wherein the gas ejecting means (34) includes a gas ejection port (34a), the gas ejected from the gas ejection port (34a) colliding against the pretreatment liquid ejected from the pretreatment liquid ejecting means (39) at a point (G) located a predetermined distance apart from the gas ejection port (34a) .

9. A substrate treatment apparatus as set forth in any of claims 1 to 8, wherein the etching liquid is a solution mixture comprising hydrofluoric acid and hydrochloric acid.

10. A substrate treatment method comprising the steps of:
bombarding liquid droplets onto a surface of a substrate (W) for pretreatment of the substrate surface, the liquid droplets being generated by mixing a pretreatment liquid comprising ammonia and an oxidizing agent with a gas; and
supplying an etching liquid onto the substrate (W) surface after the pretreatment.

11. A substrate treatment method as set forth in claim 10, wherein the oxidizing agent is hydrogen peroxide.

12. A substrate treatment method as set forth in claim 11, wherein the pretreatment liquid further comprises water.

13. A substrate treatment method as set forth in claim 12, wherein the pretreatment liquid is obtained by mixing 0,05 to 1 part by volume of aqueous ammonia, 0,1 to 1 parts by volume of hydrogen peroxide, and 5 parts by volume of water.

14. A substrate treatment method as set forth in claim 10, wherein the oxidizing agent is ozone water.

15. A substrate treatment method as set forth in claim 14, wherein the pretreatment liquid is obtained by mixing 5 to 50 party by volume of ozone water having an ozone concentration of 5 to 30 ppm, and 1 parts by volume of aqueous ammonia.

16. A substrate treatment method as set forth in any of claims 10 to 15, wherein the pretreatment step comprises the step of blowing the gas on the pretreatment liquid for the generation of the droplets of the pretreatment liquid and ejecting the liquid droplets onto the substrate (W) surface.

17. A substrate treatment method as set forth in claim 16, wherein the pretreatment step is carried out with use of a bi-fluid nozzle (68) including a pretreatment liquid ejecting means (39) for ejecting the pretreatment liquid, and a gas ejecting means (34) provided adjacent the pretreatment liquid ejecting means (39) for ejecting the gas, the gas ejecting means (34) including a gas ejection port (34a), the gas ejected from the gas ejection port (34a) colliding against the pretreatment liquid ejected from the predetermined liquid ejecting means (39) at a point (G) located a predetermined distance apart from the gas ejection port (34a).

18. A substrate treatment method as set forth in any of claims 10 to 17, wherein the etching liquid is a solution mixture comprising hydrofluoric acid and hydrochloric acid.

19. A substrate treatment method as set forth in any of claims 10 to 18, wherein the pretreatment liquid and the etching liquid each have a temperature of 20 to 28°C.

## Patentansprüche

1. Vorrichtung (1) zur Substratbehandlung, welche umfasst:
ein Vorbehandlungsmittel (68) zum Bombardieren von Flüssigkeitstropfen gegen eine Oberfläche eines Substrats (W), wobei die Flüssigkeitstropfen erzeugt werden durch Mischen einer Vorbehandlungsflüssigkeit, die Ammoniak und ein Oxidationsmittel umfasst, mit einem Gas;
ein Versorgungsmittel (7) für eine Ätzflüssigkeit zum Liefern einer Ätzflüssigkeit auf die Substratoberfläche (W); und
einen Steuerabschnitt (90), damit das Vorbehandlungsmittel (68) die Flüssigkeitstropfen gegen die Oberfläche des Substrats (W) bombardiert und damit anschließend das Versorgungsmittel (7) für Ätzflüssigkeit die Ätzflüssigkeit auf die Substratoberfläche (W) liefert.

2. Vorrichtung zur Substratbehandlung nach Anspruch 1, wobei das Oxidationsmittel Wasserstoffperoxid ist.

3. Vorrichtung zur Substratbehandlung nach Anspruch 2, wobei die Vorbehandlungsflüssigkeit ferner Wasser umfasst.

4. Vorrichtung zur Substratbehandlung nach Anspruch 3, wobei die Vorbehandlungsflüssigkeit 0,05 bis 1 Volumenteile wässrigen Ammoniak, 0,1 bis 1 Volumenteile Wassersstoffperoxid und 5 Volumenteile Wasser umfasst.

5. Vorrichtung zur Substratbehandlung nach Anspruch 1, wobei das Oxidationsmittel Ozonwasser ist.

6. Vorrichtung zur Substratbehandlung nach Anspruch 5, wobei die Vorbehandlungsflüssigkeit erhalten wird durch Mischen von 5 bis 50 Volumenteilen Ozonwasser mit einer Ozonkonzentration von 5 bis 30 ppm und 1 Volumenteil wässrigem Ammoniak.

7. Vorrichtung zur Substratbehandlung nach einem der Ansprüche 1 bis 6, wobei das Vorbehandlungsmittel (68) eine Doppelfluiddüse (68) umfasst, die ein Vorbehandlungsflüssigkeitsauswurfmittel (39) zum Auswerfen der Vorbehandlungsflüssigkeit und ein Gasauswurfmittel (34), das angrenzend an das Vorbehandlungsflüssigkeitsmittel (39) zum Auswerfen eines Gases vorgesehen ist, einschließt wobei die Doppelfluiddüse (68) in der Lage ist, das aus dem Gasauswurfmittel (34) ausgeworfene Gas auf die aus dem Vorbehandlungsflüssigkeitsauswurfmittel (39) ausgeworfene Vorbehandlungsflüssigkeit für die Erzeugung der Tröpfen der Vorbehandlungsflüssigkeit und zum Auswerfen der Flüssigkeitströpfchen auf die Substratoberfläche (W) zu blasen.

8. Vorrichtung zur Substratbehandlung nach Anspruch 7, wobei das Gasauswurfmittel (34) eine Gasauswurföffnung (34a) einschließt, wobei das aus der Gasauswurföffnung (34a) ausgeworfene Gas gegen die aus dem Vorbehandlungsflüssigkeitsauswurfmittel (39) ausgeworfene Vorbehandlungsflüssigkeit an einem Punkt (G) trifft, der einen vorgegebenen Abstand entfernt von der Gasauswurföffnung (34a) angeordnet ist.

9. Vorrichtung zur Substratbehandlung nach einem der Ansprüche 1 bis 8, wobei die Ätzflüssigkeit eine Lösungsmischung ist, die Flusssäure und Salzsäure umfasst.

10. Verfahren zur Substratbehandlung, welches die Schritte umfasst:
Bombardieren von Flüssigkeitstropfen auf eine Oberfläche eines Substrats (W) zur Vorbehandlung der Substratoberfläche, wobei die Flüssigkeitstropfen erzeugt werden durch Mischen einer Ammoniak und ein Oxidationsmittel umfassenden Vorbehandlungsflüssigkeit mit einem Gas; und
Liefern einer Ätzflüssigkeit auf die Substratoberfläche (W) nach der Vorbehandlung.

11. Verfahren zur Substratbehandlung nach Anspruch 10, wobei das Oxidationsmittel Wasserstoffperoxid ist.

12. Verfahren zur Substratbehandlung nach Anspruch 11, wobei die Vorbehandlungsflüssigkeit ferner Wasser umfasst.

13. Verfahren zur Substratbehandlung nach Anspruch 12, wobei die Vorbehandlungsflüssigkeit erhalten wird durch Mischen von 0,05 bis 1 Volumenteilen wässrigen Ammoniak, 0,1 bis 1 Volumenteilen Wasserstoffperoxid und 5 Volumenteilen Wasser.

14. Verfahren zur Substratbehandlung nach Anspruch 10, wobei das Oxidationsmittel Ozonwasser ist.

15. Verfahren zur Substratbehandlung nach Anspruch 14, wobei die Vorbehandlungsflüssigkeit erhalten wird durch Mischen von 5 bis 50 Volumenteilen Ozonwasser mit einer Ozonkonzentration von 5 bis 30 ppm und 1 Volumenteil wässrigen Ammoniak.

16. Verfahren zur Substratbehandlung nach einem der Ansprüche 10 bis 15, wobei der Vorbehandlungsschritt den Schritt eines Blasens des Gases auf die Vorbehandlungsflüssigkeit für die Erzeugung der Tropfen der Vorbehandlungsflüssigkeit und eines Auswerfens der Flüssigkeitstropfen auf die Substratoberfläche (W) umfasst.

17. Verfahren zur Substratbehandlung nach Anspruch 16, wobei der Vorbehandlungsschritt durchgeführt wird durch Verwendung einer Doppelfluiddüse (68), die ein Vorbehandlungsflüssigkeitsauswurfimittel (39) zum Auswerfen der Vorbehandlungsflüssigkeit und ein Gasauswurfmittel (34), das benachbart zum Vorbehandlungsflüssigkeitsauswurfmittel (39) zum Auswerfen des Gases bereitgestellt ist, einschließt, wobei das Gasauswurfmittel (34) eine Gasaufwurföffnung (34a) einschließt, wobei das aus der Gasauswurföffnung (34a) ausgeworfene Gas auf die aus dem Vorbehandlungsflüssigkeitsauswurfmittel (39) ausgeworfene Vorbehandlungsflüssigkeit an einer Stelle (G) trifft, die einen vorgegebenen Abstand entfernt von der Gasauswurföffnung (34a) angeordnet ist.

18. Verfahren zur Substratbehandlung nach einem der Ansprüche 10 bis 17, wobei die Ätzflüssigkeit eine Lösungsmischung ist, die Flusssäure und Salzsäure umfasst.

19. Verfahren zur Substratbehandlung nach einem der Ansprüche 10 bis 18, wobei die Vorbehandlungsflüssigkeit und die Ätzflüssigkeit jeweils eine Temperatur von 20 bis 28°C aufweisen.

## Revendications

1. Appareil de traitement de substrat (1) comprenant :
un moyen de prétraitement (68) pour bombarder des gouttelettes de liquide contre une surface d'un substrat (W), les gouttelettes de liquide étant générées en mélangeant un liquide de prétraitement comprenant de l'ammoniaque et un agent oxydant avec un gaz ;
un moyen fournissant un liquide corrosif (7) pour fournir un liquide corrosif sur la surface du substrat (W) ; et
une partie de commande (90) pour entraîner le bombardement par le moyen de prétraitement (68) de gouttelettes de liquide contre la surface du substrat (W) et ensuite, pour entraîner la fourniture par le moyen de fourniture du liquide corrosif (7) du liquide corrosif sur la surface du substrat (W).

2. Appareil de traitement de substrat selon la revendication 1, dans lequel l'agent oxydant est le peroxyde d'hydrogène.

3. Appareil de traitement de substrat selon la revendication 2, dans lequel le liquide de prétraitement comprend en outre de l'eau.

4. Appareil de traitement de substrat selon la revendication 3, dans lequel le liquide de prétraitement comprend 0,05 à 1 partie en volume d'ammoniaque aqueuse, 0,1 à 1 partie en volume de peroxyde d'hydrogène et 5 parties en volume d'eau.

5. Appareil de traitement de substrat selon la revendication 1, dans lequel l'agent oxydant est l'eau ozonisée.

6. Appareil de traitement de substrat selon la revendication 5, dans lequel le liquide de prétraitement est obtenu en mélangeant 5 à 50 parties en volume d'eau ozonisée ayant une concentration en ozone de 5 à 30 ppm et 1 partie en volume d'ammoniaque aqueuse.

7. Appareil de traitement de substrat selon l'une quelconque des revendications 1 à 6, dans lequel le moyen de prétraitement (68) comprend une buse à 2 fluides (68) comprenant un moyen d'éjection de liquide de prétraitement (39) pour éjecter le liquide de prétraitement, et un moyen d'éjection de gaz (34) monté au niveau adjacent du moyen de liquide de prétraitement (39) pour éjecter un gaz, la buse à deux fluides (68) étant capable d'insuffler le gaz éjecté du moyen d'éjection du gaz (34) sur le liquide de prétraitement éjecté du moyen d'éjection du liquide de prétraitement (39) pour générer les gouttelettes de liquide de prétraitement et éjecter les gouttelettes de liquide sur la surface du substrat (W).

8. Appareil de traitement de substrat selon la revendication 7, dans lequel le moyen d'éjection de gaz (34) comprend un orifice d'éjection de gaz (34a), le gaz éjecté de l'orifice d'éjection de gaz (34a) entrant en collision contre le liquide de prétraitement éjecté du moyen d'éjection du liquide de prétraitement (39) à un point (G) situé à une distance prédéterminée séparée de l'orifice d'éjection du gaz (34a).

9. Appareil de traitement de substrat selon l'une quelconque des revendications 1 à 8, dans lequel le liquide corrosif est un mélange en solution comprenant de l'acide fluorhydrique et de l'acide chlorhydrique.

10. Procédé de traitement de substrat comprenant les étapes consistant à :
bombarder des gouttelettes de liquide sur une surface d'un substrat (W) pour prétraiter la surface du substrat, les gouttelettes de liquide étant générées en mélangeant un liquide de prétraitement comprenant de l'ammoniaque et un agent oxydant avec un gaz ; et
fournir un liquide corrosif sur la surface du substrat (W) après le prétraitement.

11. Procédé de traitement de substrat selon la revendication 10, dans lequel l'agent oxydant est le peroxyde d'hydrogène.

12. Procédé de traitement de substrat selon la revendication 11, dans lequel le liquide de prétraitement comprend en outre de l'eau.

13. Procédé de traitement de substrat selon la revendication 12, dans lequel le liquide de prétraitement est obtenu en mélangeant 0,05 à 1 partie en volume d'ammoniaque aqueuse, 0,1 à 1 partie en volume de peroxyde d'hydrogène et 5 parties en volume d'eau.

14. Procédé de traitement de substrat selon la revendication 10, dans lequel l'agent oxydant est l'eau ozonisée.

15. Procédé de traitement de substrat selon la revendication 14, dans lequel le liquide de prétraitement est obtenu en mélangeant 5 à 50 parties en volume d'eau ozonisée ayant une concentration en ozone de 5 à 30 ppm et 1 partie en volume d'ammoniaque aqueuse.

16. Procédé de traitement de substrat selon l'une quelconque des revendications 10 à 15, dans lequel l'étape de prétraitement comprend l'étape consistant à insuffler le gaz sur le liquide de prétraitement pour générer des gouttelettes de liquide de prétraitement et à éjecter les gouttelettes de liquide sur la surface du substrat (W).

17. Procédé de traitement de substrat selon la revendication 16, dans lequel l'étape de prétraitement est réalisée en utilisant une buse à 2 fluides (68) comprenant un moyen d'éjection de liquide de prétraitement (39) pour éjecter le liquide de prétraitement, et un moyen d'éjection de gaz (34) monté au niveau adjacent au moyen d'éjection du liquide de prétraitement (39) pour éjecter le gaz, le moyen d'éjection du gaz (34) comprenant un orifice d'éjection de gaz (34a), le gaz éjecté depuis l'orifice d'éjection de gaz (34a) entrant en collision contre le liquide de prétraitement éjecté du moyen d'éjection du liquide de prétraitement (39) à un point (G) situé à une distance prédéterminée séparée de l'orifice d'éjection du gaz (34a).

18. Procédé de traitement de substrat selon l'une quelconque des revendications 10 à 17, dans lequel le liquide corrosif est un mélange en solution comprenant de l'acide fluorhydrique et de l'acide chlorhydrique.

19. Procédé de traitement de substrat selon l'une quelconque des revendications 10 à 18, dans lequel le liquide de prétraitement et le liquide corrosif ont respectivement une température de 20 à 28° C.
